# EUROPEAN PATENT SPECIFICATION

(11) **EP 1 195 817 B1**
(45) Date of publication and mention of the grant of the patent: **14.12.2011**
(21) Application number: 01203269.4
(22) Date of filing: 30.08.2001
(51) Int. Cl.: H01L 27/148

(54) **Method for reducing dark current in charge coupled devices**
Verfahren zur Reduktion des Dunkelstromes in Ladungsverschiebungselementen
Méthode pour la réduction du courant d'obscurité dans des dispositifs à couplage de charge

(30) Priority: 12.09.2000 US 660105
(43) Date of publication of application: 10.04.2002
(73) Proprietor: Eastman Kodak Company, Rochester, NY 14650-2201 (US)
(72) Inventor: Losee, David Lawrence, c/o Eastman Kodak Company, Rochester, New York 14650-2201 (US); Parks, Christopher, c/o Eastman Kodak Company, Rochester, New York 14650-2201 (US)
(74) Representative: Weber, Etienne Nicolas

(56) References cited:
- EP-A- 1 137 071
- WO-A-91/03840
- US-A- 3 845 295
- US-A- 5 115 458
- US-A- 5 151 380

## Description

The present invention relates to a method for reducing the level of dark current whithin an interline CCD image sensor.

Charge coupled devices (CCDs) that are used as image sensors are typically formed in lightly doped silicon materials. Light incident on the device and penetrating into the silicon produces electrons and holes in numbers proportional to the incident light intensity. The photogenerated electrons, having a higher mobility than the holes, are the preferred carrier to be collected and detected in such devices. These photogenerated electrons are transported in channels formed in lightly doped p-type silicon. Both, so-called, frame-transfer and interline transfer type CCD image sensing devices are typically fabricated in such lightly doped silicon. In interline transfer type devices and in some types of frame transfer type devices this is a lightly doped and relatively deeply diffused p-type region on an n-type silicon substrate. We will refer to such deeply diffused p-type regions as a p-well. Other types of frame transfer type devices may be fabricated in lightly doped p-type epitaxial silicon layers. Additional p-type dopant can be placed within surface regions of the silicon to form barriers and channel stops. These barriers and channel stops operate to confine signal charge within the CCD shift register (channel stops), in interline transfer type devices they can confine charge within the photodiode regions (barriers) and also separate individual phases of the CCD (barriers). The p-type doping used in these channel stop regions can provide a conductance path for movement of holes in and out of the active areas of the device. The conductance of these channel stops, however, is relatively low and, in certain circumstances, additional means are required to provide needed conductivity for the movement of the holes. An example of one means is described in US-A-5,151,380, where a contact is formed and a metal conductor is added to provide sufficient conductance. One situation which can require a rapid and long distance movement of holes is in the, so-called, accumulation mode clocking of the CCD shift registers as will be described in the paragraphs below. Therefore, a shortcoming in the prior art exists in that there is a need for such added conductors to provide for conductance of hole charge in CCD image sensing devices operating in this mode of clocking.

For CCD image sensors in general, it is desirable to reduce the generation and collection of thermally generated charge produced either in photodiode regions or in the shift register regions of the device. The rate of production of such thermally generated charge is referred to as dark current. Dark current is undesirable because the thermally generated charge cannot be easily distinguished from the signal charges produced by light exposure. A common approach to reduce the dark current generated in the photodiode regions in interline transfer devices is to provide a surface p-type region with an accumulation of holes. Similarly, to reduce the dark current emanating from the CCD shift register surface regions, it is also desirable to maintain an accumulation of holes at the silicon surface. A four phase full frame type CCD device and clock sequence which accomplishes this has been described in US-A-4,963,952, where a significant reduction in dark current generated under the CCD gates was observed when holes were accumulated beneath all gates. A gate which is biased in such a way to maintain the accumulation of holes at the silicon surface, is said to be in accumulation. A gate which is biased so that holes are not present is said to be in depletion.

Commonly-assigned US-A-5,115,458 and international application WO 91/03840 disclose additional invention related specifically to clocking techniques to reduce dark current in, so called, true two phase CCDs with a frame transfer architecture. By their description, true two phase CCD shift registers are those wherein each of the gate electrodes consist of a single conductive element with a storage and barrier region provided within the charge transfer channel. Description of such true two phase CCD shift registers as applied to interline transfer architecture has been disclosed in commonly-assigned US-A-4,908,518 and US-A-5,235,198. While the illustrations in this invention depict such true two phase CCD shift registers, it should be clear that examples not forming part of the claimed invention apply to other two phase CCDs. Some examples may be found in references such as C. H. Sequin and M. F. Tompsett, Charge Transfer Devices, Academic Press, N.Y. 1975, pgs. 32-42.

US patent 3,845,295 discloses the radiation induced charge signals accumulated at the radiation sensors of a radiation sensing array are processed to improve the contrast of the sensed image. Of the total charge signal present at each sensor, only that portion greater than a given charge signal level is shifted into the stage at that location of a charge-coupled register. The remainder-the major portion of the charge signal, is conducted to a current sink, the radiation sensors being reset to a given reference voltage level in the process.

European patent application EP 1 137 071 discloses a structure for a fast-dump gate for charge coupled devices that does not require a separate contact to a drain region instead using the existing drain of a lateral overflow (LOD) typically used for antiblooming purposes. LOD structures are typically used on full-frame CCD image sensors. By using the LOD as the drain for a fast-dump gate, a separate opening in the gate electrode for the drain contact is avoided, thereby making the structure more compact. Gate control is provided by etching a hole in the CCD gate electrode over the overflow channel region of the LOD structure, and overlaying this with one of the subsequent gate electrode layers. This subsequent gate electrode is then used to control the fast-dump operation. Timing is shown for a two-phase CCD being operated with accumulation-mode clocking. Other types of CCDs and clocking schemes may be used. Another advantage of this structure is that it does not require any additional masking or processing steps when built, using a double electrode CCD process that employs a typical LOD structure.

CCD area arrays are typically arranged as rows and columns of light sensing elements, or pixels. In the typical operation of such a CCD image sensor array, charge is transferred row-by-row through a set of vertical shift registers, into a horizontal shift register, then the charges are transferred by the horizontal shift register to a detection circuit. The time during which a row of charges is transferred through the horizontal shift register is called the horizontal read-out time. During this time the vertical shift register CCD gates are held at some set of constant voltages. The vertical CCD gate voltages are clocked only during the brief period of time required to transfer a row of charge into the horizontal register, and are quiescent otherwise. This period of quiescence constitutes a majority of the time of operation of the device. It is during this period of quiescence that dark current problems arise in the vertical shift registers.

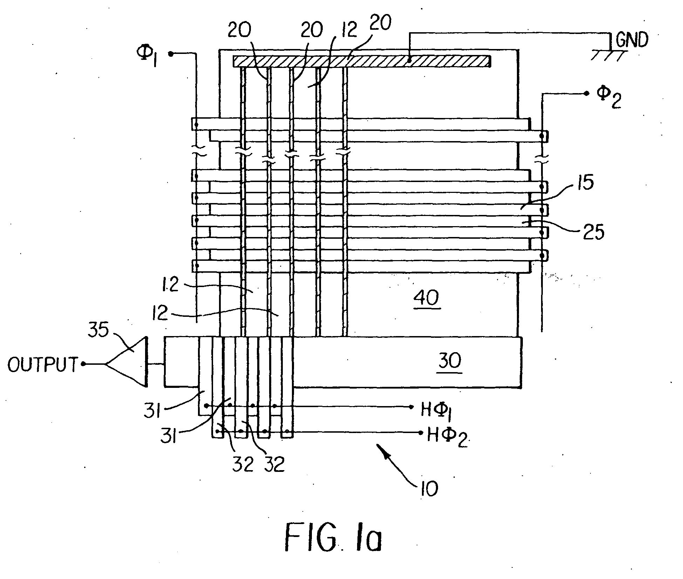

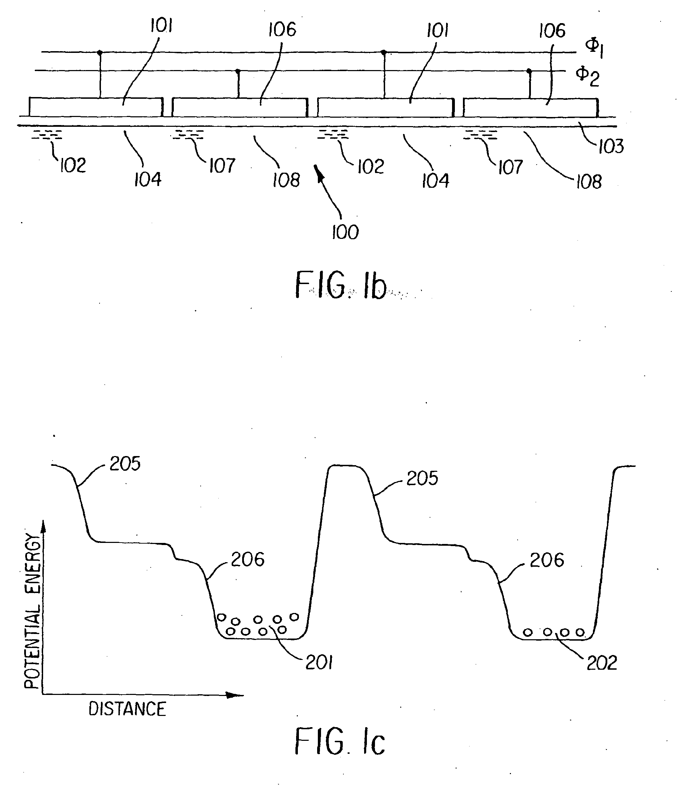

A true two phases CCD refers to a device in which there are two physical gates per pixel, with each gate having both a transfer and a storage region formed in the silicon under it. There are two voltage phase lines Φ₁ and Φ₂. The charge coupling concept is used in frame transfer and interline transfer CCD image sensing devices. An example of a frame transfer area image sensor 10 is shown in FIG. 1. Indicated, schematically, in FIG. 1a are the components of such a device, namely: a vertical shift register array 40, arranged with rows and columns of pixels; channel stop regions 20, arranged to provide vertical channels 12; vertical gate electrodes 15 and 25; a horizontal shift register region 30, with gates 31 and 32; and, output amplifier 35. Electrical connections, to channel stop region 20, vertical gates 15 and 25 and horizontal gates 31 and 32, are also indicated. A schematic cross-section for a true two phases CCD is shown in FIG. 1b. A true two phases CCD is described in detail in commonly assigned US-A- 4,613,402. A true two phases CCD has storage and transfer regions beneath each phase gate. In FIG. 1b the phase gates are labeled by 101 and 106, and are situated above a silicon substrate 100 and isolated from the substrate by an insulating layer 103. The transfer and storage regions for these gates are indicated, respectively, as regions 102 and 104 for gates 101 (Φ₁) and 107 and 108 for gates 106 (Φ₂). In this drawing, additional dopants are indicated to be present in regions 102 and 107 in order to provide a suitable potential energy profile for efficient transfer of charge in the CCD register. These dopants are in addition to other dopants commonly introduced to provide, for example, a buried channel, for transport of signal charges. In FIG. 1c, the potential energy profile in the channel beneath the gates is indicated for the condition that voltage Φ₂ is more positive than the voltage Φ₁. For this voltage condition charge packets 201 and 202 reside in the storage regions 108 beneath the respective Φ₂ gates. The dopants in regions 102 and 107 produce the potential energy steps 205 and 206 which provide the directionality for charge transfer.

In this disclosure only n-buried channel devices will be considered. This invention applies equally to p-buried channel devices. For an n channel CCD, which is illustrated, the buried channel is formed by an n-type doping in a p-type substrate or in a p-well in an n-type substrate. The transfer and storage buried channel regions are differentiated by less or more of the n-buried channel doping, respectively. Commonly-assigned US-A-4,613,402 discloses a detailed procedure for making true two phase CCD devices. In a buried channel CCD, dark current arises from three main sources: (1) generation from a midgap state resulting from either the disrupted lattice or an impurity at a depleted Si-SiO₂ interface, (2) generation in the depletion region, that is, a region depleted of mobile charge, as a result of an impurity or defect with a midgap state and (3) diffusion of electrons to the buried channel from the substrate. All three sources, result in spurious charges being collected as signal in the buried channel. The mechanism for dark current generation both at the surface and in the depletion region has been described in commonly-assigned US-A-5,115,458. It is an object of this invention to reduce the surface state component of dark current.

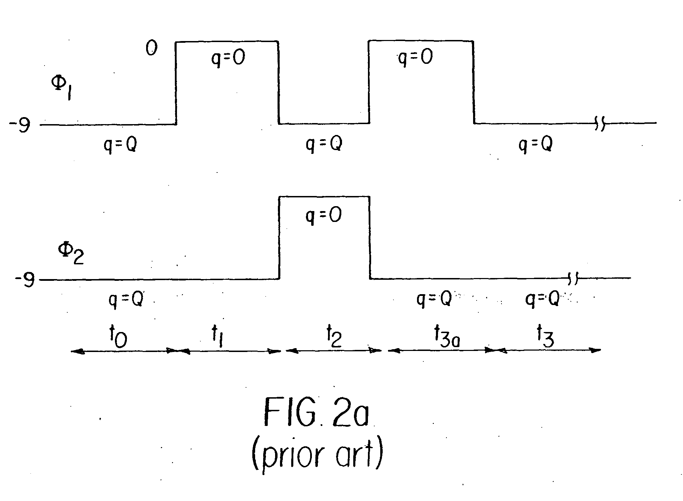

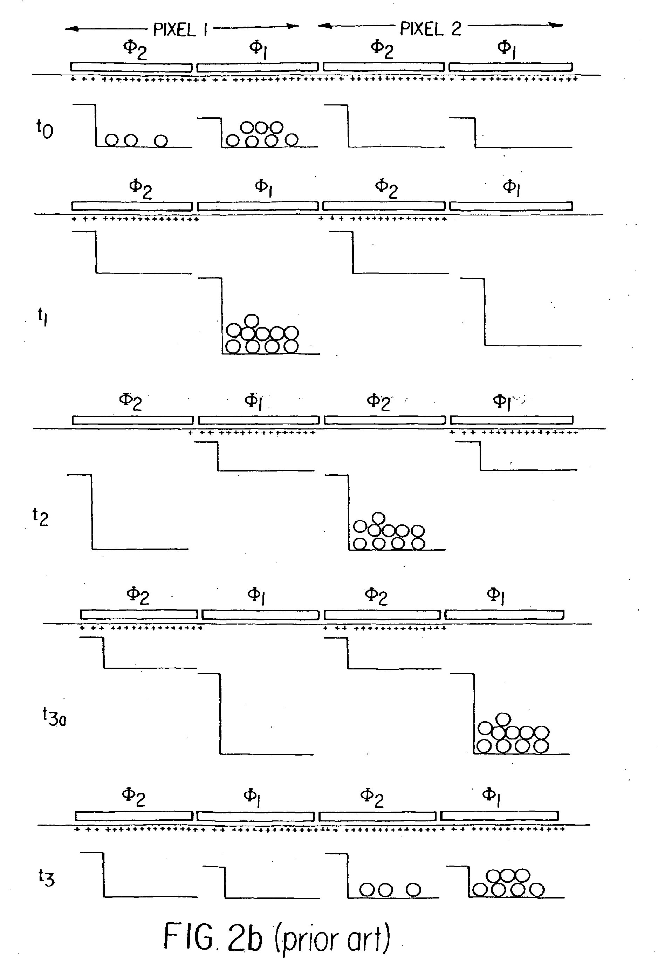

A clocking sequence which accomplishes such an accumulation of surface holes at all gates of the vertical shift register for a majority of the time, is called, accumulation mode clocking. One such clocking sequence for the vertical shift register of a two-phase CCD device is diagrammed in FIG. 2. In the first part of this figure, FIG. 2a, the clock voltages which are applied to first phase, Φ₁, and second phase, Φ₂, are diagrammed as a function of time. Time intervals, to through t₃, designate the various parts of this clock sequence. The charge transfer process resulting from the clocking diagrammed in FIG. 2a is shown schematically in FIG. 2b, where, for the various time periods indicated in FIG. 2a, the potential energy, and the location of signal electrons, are schematically indicated. In FIG. 2b, the vertical direction represents the potential energy of electrons and the horizontal direction representing distance along the CCD shift register. In FIG. 2b, the gate pair, Φ₂ and Φ₁, on the left, define a first pixel position and the gate pair Φ₂ and Φ₁, on the right define a second pixel position. In FIG. 2b, the signal charges, denoted by the circular objects, and the hole charges, denoted by the + signs, are diagrammed at times t₀ through t₃. Also, in this figure, the barrier region channel potential under the Φ₁ gate is taken to be higher (that is a lower potential energy barrier) than the channel potential under the barrier region of the Φ₂ gate. This situation is similar to that described in commonly-assigned US-A-5,235,198 and the clocking was termed, by them, as a "spill backward" mode. The reason for this terminology will be indicated below.

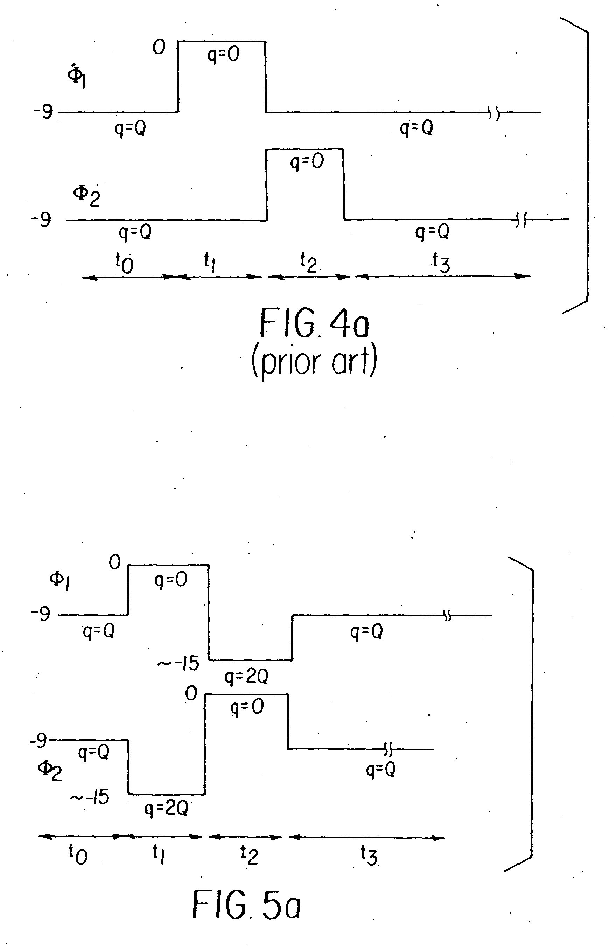

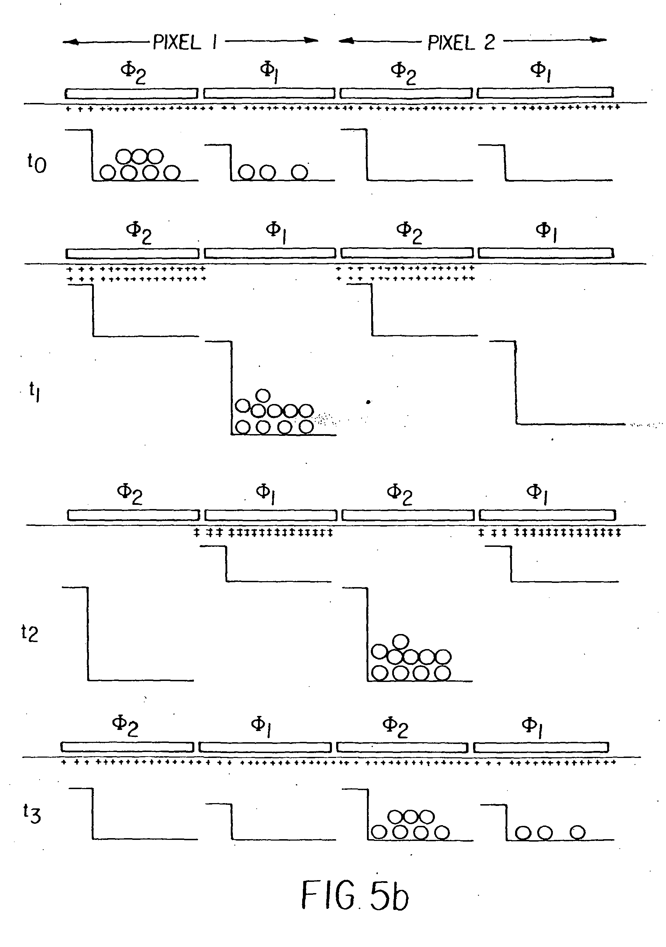

As represented in FIG. 2b, the positive clock voltage transitions produce deeper potential energy regions for electrons and higher potential energy regions for holes. Conversely, the more negative clock voltages produce lower potential energy regions for holes and higher potential energy regions for electrons. This clocking sequence is equivalent to that shown in FIG. 5 of commonly-assigned US-A-5,115,458. Note that for this example, the barrier region electron's potential energy on the left side of the Φ₁ gate is lower than the potential energy of the barrier region on the left side of the Φ₂ gate. The upshot of this potential energy difference is that, during the period when both gates are in accumulation, signal charge may be stored beneath either or both of the CCD gates. This particular mode of operation is called the "spill backward mode" because any signal charge in excess of what can be accommodated under the accumulated gate, is spilled backwards, in this case to the Φ₂ gate, when the clocks return to the hole accumulated state at time t₃.

In this illustration, it should be noted that the total hole charge under the gate pairs of each pixel, during each successive interval of the clocking, does not remain constant. For example, when both gates are biased negative (-9 volts is chosen as an example) an amount of holes, Q, is accumulated under each gate, and, thus, the total charge under the pair of gates is 2Q. The hole charge, q, under each gate, during each interval of time, is also indicated in the timing diagram FIG. 2a. When one gate is brought more positive, for example, to 0 volts in this illustration, the total hole charge is reduced to only 1Q. The excess hole charge, an amount Q per pixel, must be removed in some way. It is evident that approximately half of the total accumulated hole charge for each pixel must be removed in the transitions between times to and t₁, and then replaced between t₃ₐ and t₃, respectively.

The typical path for such hole charge removal or replacement is via a p-doped region such as the channel stop. For large devices, the net charge that must be moved in this way is significantly impeded by the relatively high resistance of the p-type regions. While this is true for any CCD operating in accumulation mode, this is a particularly troublesome problem for devices which are fabricated in deeply diffused p-doped regions on an n-type substrate. The problem becomes more severe as the area of the devices are made larger. This deeply diffused p-type region, referred to as a p-well, is typically isolated or only weakly connected with surface p-regions such as channel stops. The total amount of charge which must be drained off during the time one of the gates is in depletion is nQ, where n is the total number of pixels in the image sensor. During the time required to drain off the excess hole charge, the local value of the p-well bias moves, particularly in the central regions of the device, creating an undesirable biasing which leads to poor imaging properties for the device. This undesirable potential variation is sometimes referred to as p-well bounce. There is, thus, a shortcoming within the prior art in avoiding p-well bounce when attempting to employ accumulation mode clocking.

It should be readily apparent that there remains a need within the art for a method and apparatus that can be used to clock image sensing devices in accumulation mode that does not result in dark current signal in interline transfer type CCD image sensors. In particular, it should be apparent that there is a need within the art for a method of operation of interline CCD devices with reduced dark current and which also avoids the need to transport hole charge by large distances. Prior art devices, as previously discussed, have a problem in not providing a suitable clocking sequence which results in lowered dark current signals in large area devices, and in particular in interline transfer type CCD image sensors.

In CCD image sensors and, in particular, in devices formed in a p-well, such as interline transfer type CCD image sensors, photogenerated charge is first collected in an array of rows and columns of photosensitive sites, photodiodes or photocapacitors. These photosites are situated adjacent to the gates of CCD shift registers arranged column-wise in the array. For an interline transfer CCD device these photosites are photodiodes. Charge from the photodiodes is transferred to corresponding CCD gates, typically once per frame time, by application of a positive voltage pulse to one of the sets of gates, such pulse voltage being more positive than that required for transfer of charge within the CCD shift register.

It is an object of this invention to reduce the dark current which is generated during the horizontal read-out, period.

It is a further object of the present invention to eliminate the need for added conductors in CCD image sensing devices operating in the, so called, accumulation mode of clocking.

It is still another object of the invention to maintain accumulation mode clocking while avoiding p-well bounce.

It is a further object of this invention to disclose a suitable clocking sequence which reduces the dark current signal in interline transfer type CCD image sensors and in image sensors utilizing a deeply diffused p-well.

The present invention addresses the above discussed needs within prior art by providing a method for reducing dark current within an interline CCD image sensor according to claim 1.
FIG. 1a is a schematic representation of a prior art CCD image sensor;
FIG. 1b is a schematic cross-sectional view of a prior art true two phase CCD shift register;
FIG. 1c is a diagram of the potential energy for electrons in a prior art CCD channel as a function of distance along a portion of the channel of a true two phase CCD shift register;
FIG. 2a is a prior art clocking sequence for the vertical shift register of a two-phase, interline CCD device using accumulation mode clocking, where the vertical axis of the drawing represents the applied voltage and the horizontal axis represents time;
FIG. 2b is a sequence of schematic diagrams of the charge transfer process during the clocking sequence of FIG. 2a, where the vertical axes represent the potential energy for electrons, the horizontal axes represent position along the CCD shift register, and the + signs represent hole charges accumulated at the silicon surface;
FIG. 3a is an illustration of a modified clocking sequence as envisioned by the present invention wherein both sets of gates are biased into accumulation, holding a total charge 2Q beneath each gate pair during the entire clock sequence;
FIG. 3b is a schematic diagram of the charge transfer process during the clocking sequence of FIG. 3a;
FIG. 4a is an alternative prior art accumulation mode clocking sequence;
FIG. 4b is a schematic illustration of the charge transfer process associated with the clocking sequence of FIG. 4a;
FIG. 5a is a modified accumulation mode clocking sequence as envisioned by the present invention;
FIG. 5b is a schematic illustration of the charge transfer process associated with the clocking sequence of FIG. 5a;
FIG. 6 is a timing diagram illustrating the clocking sequence employed for an interline device using the accumulation mode clocking of the present invention; and
FIG. 7 is a graph of measurements from an example device, comparing the dark current generated in the CCD shift register in depletion and accumulation modes with that of the photodiodes;

As discussed above, during the so-called accumulation mode clocking of the vertical shift register, one set of gates changes from a condition where holes are accumulated beneath the gate, at the Si-SiO₂ interface, to a condition where the surface is depleted of holes. This results in excess hole charge being present which must be drained off. During the time required to drain off the excess hole charge, the p-well or substrate potential moves. This undesirable potential variation is referred to as p-well bounce. The present invention provides a means for maintaining accumulation mode clocking while avoiding the p-well bounce.

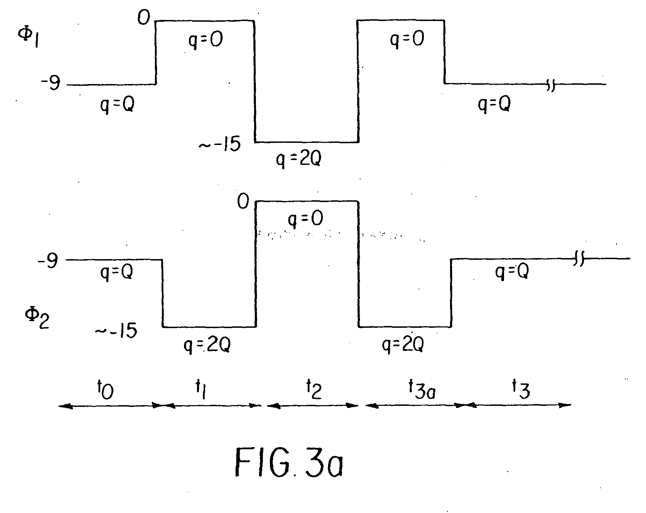

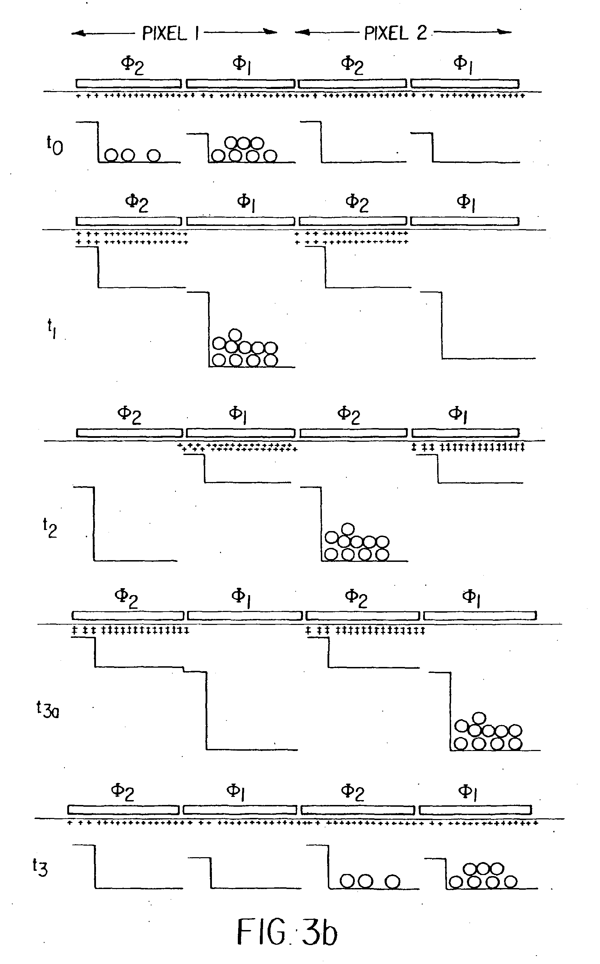

The fundamental problem that results in p-well bounce is that of disposal of the excess hole charges accumulated beneath one of the sets of gates of the CCD when that phase is switched out of accumulation and into depletion, and, conversely, the replenishment of the required hole charges when returning to the gates to accumulation. This problem becomes more acute for larger area devices because of the greater distances over which this excess charge must be transported. The present invention discloses a method of accumulation mode clocking for a two phase CCD shift register such that the distance over which most or all of the excess charge is transported is substantially reduced, thus reducing the p-well bounce. One such modified clocking sequence is shown in FIG. 3a, which is a modification, according to the present invention, of the spill-backwards mode previously discussed. Here, during time t₀, both sets of gates are biased into accumulation, holding charge Q beneath each gate. In time interval t₁, the gate indicated by Φ₁ is switched to a higher voltage which drives it into depletion, and Φ₂ is switched to a more negative voltage, the voltage being adjusted such that the equilibrium hole charge, now equal to 2Q, is held beneath the Φ₂ gate. During time t₂, Φ₂ is switched into depletion and Φ₁ is then switched to a more negative voltage such that hole charge equal to 2Q is held beneath the Φ₁ gate. During time t₃ₐ, Φ₁ is again switched to a more positive voltage, and Φ₂ is switched to more negative voltage such that hole charge equal to 2Q is again held beneath the Φ₂ gate. This sequence results in signal charges being transported through one complete CCD stage. At time t₃ both gates are returned to the bias voltages such that hole charge Q is held beneath each of the gates of the CCD. It is to be noted that the movement of holes during this sequence is very much reduced compared with the prior art. The distance over which the excess charge has been transported is approximately the length of one of the CCD gates, thus substantially reducing the distance and quantity of hole charge movement, and, consequently reducing the p-well bounce. FIG. 3b shows schematically, and step by step, the charge transfers occurring during this clocking sequence.

In FIG. 3b, the + symbols indicate the hole charges accumulated under each gate during each step of this clock sequence and the circles represent signal electrons. It is evident that the hole charge Q under, say, the Φ₁ gate, during time t₀, has been collected and held under the adjacent Φ₂ gate during time t₁. This same quantity of hole charge is transferred to gate Φ₁ and held there during time interval t₂. Again, the charge has only moved by one gate length. A similar movement of charge occurs between times t₂ and t₃ₐ. Finally, during time t₃, hole charge is again distributed, approximately equally, beneath both Φ₁ and Φ₂ gates. Time interval t₃ corresponds to the time required to read out a line of charge from the horizontal shift register.

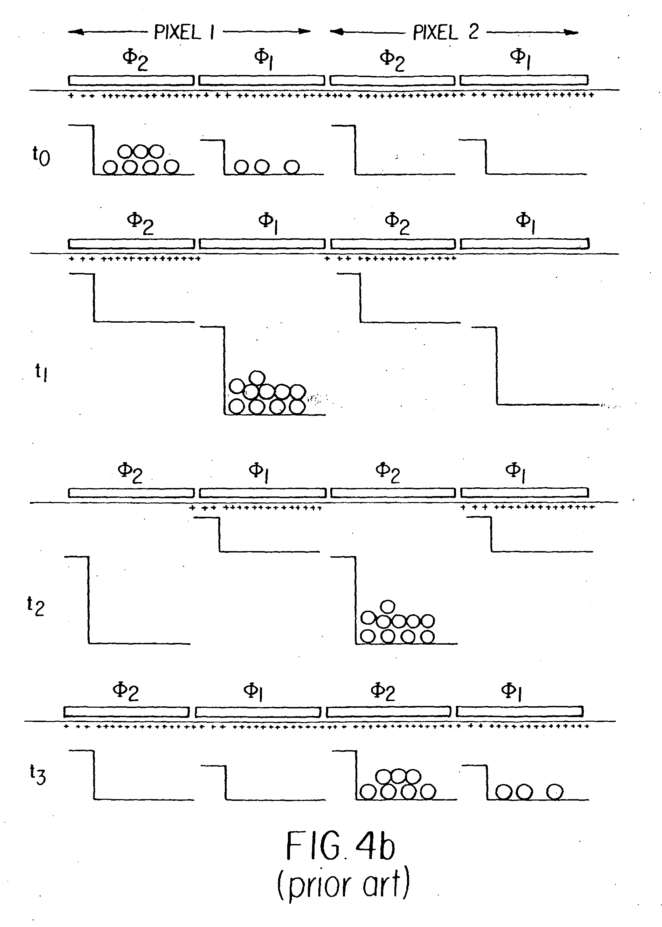

Another prior art sequence for accumulation mode clocking is shown in FIG. 4a. Here, during time t₀, both phases are at a negative voltage sufficient to accumulate hole charge Q beneath each gate, and the total hole charge beneath the pair of gates is 2Q. During time t₁, Φ₁ is switched high, and Φ₂ is maintained low. The total stored hole charge is now only Q. Again, the excess hole charge must be dispersed. Upon the transition from time t₂ to t₃, additional holes, approximately of amount Q, must again be supplied to each pair of gates. The charge transfer process for each step of the clock sequence is schematically indicated in FIG. 4b. Again, as in FIG. 2, in the barrier region, on the left side of the Φ₁ gate, the electron's potential energy is lower than the potential energy of the barrier region on the left side of the Φ₂ gate. The upshot of this potential energy difference is that during the period when both gates are in accumulation that charge may be stored beneath either or both of the CCD gates. In this case, signal charge in excess of what can be stored under the accumulated Φ₂ gate is spilled forward, to be held under the Φ₁ gate, hence the designation, spill forward clocking. Again, especially for large area device, total hole charge nQ, must be either removed or replenished in this clocking sequence.

To reduce or eliminate the resulting p-well bounce, in accordance with the present invention, a modified clock sequence may be used as shown in FIG. 5a. In this figure, in a manner similar to the method shown in FIG. 3, an additional negative voltage can be applied to cause the excess hole charge to be transferred to the Φ₂ gate during time t₁. During time t₂, Φ₂ is switched high and Φ₁ is then switched to a more negative voltage such that hole charge, equal to 2Q, is now held beneath the Φ₁ gate. During time t₃, Φ₁ and Φ₂ are both returned to a bias which accumulates charge Q under each gate respectively. The charge transfer for this clock sequence is shown schematically in FIG. 5b, where the charge distributions during each time interval are diagrammed.

The forgoing discussion applies to the operation of the vertical shift register clocking during the line by line readout of the image sensing device. In an interline transfer type image sensor, additional voltage pulses are provided to transfer photogenerated charges from the photodiodes associated with each pixel to the vertical shift registers. Typically, this entails application, once per frame, of a more positive going pulse to one of the CCD gates, so as to transfer photocharge from the diodes into the corresponding vertical CCD stages.

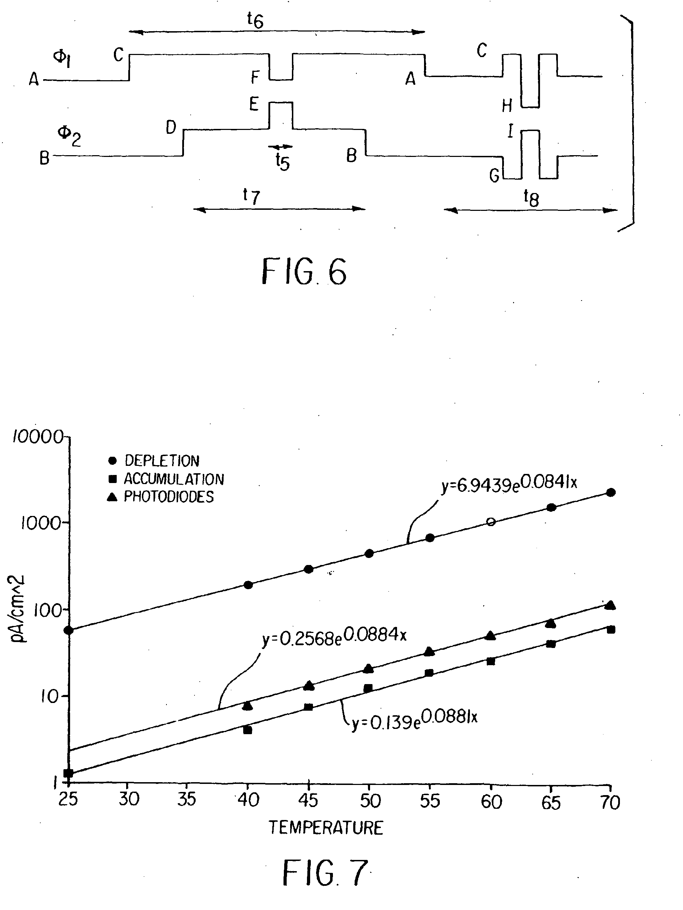

FIG. 6 illustrates the typical clocking of an interline transfer image sensor in accordance with the confines of the present invention. The photodiodes will integrate for a predetermined period of time, after which it is required that a high level pulse be applied to one of the CCD gates in order to transfer photocharge out of the photodiodes and into the CCD shift registers. This transfer from the photodiodes to the vertical shift registers happens once per frame. This high level pulse is indicated by the timing diagram shown in FIG. 6 by the pulse on the Φ₂ phase that occurs during the time period t₅. In most devices such a pulse is typically applied only once per frame time or once per field time. In FIG. 6 this is shown to occur within a relatively longer time interval t₆. During time t₆ the Φ₁ clock first rises from level A to level C. During time interval t₇, but within t₆, clock phase Φ₂ rises similarly from level B to level D, during time interval t₇. Both levels A and B are such that the CCD surfaces beneath the gates accumulates holes, that is -9 volts. At a later time, during interval t₅, within t₆, and t₇, a positive pulse to voltage E is applied to Φ₂ and, simultaneously, a negative pulse to level F is applied to Φ₁. The voltage level E is sufficient to empty the photocharge out of the photodiodes and into the corresponding CCD stages in the vertical shift register. Subsequently, Φ₂ is returned to level B' at the end of t₇ and Φ₁ is returned to level A' at the end of t₆. The vertical shift register is subsequently operated with the accumulated mode clocking sequence during time interval t₈ with the voltage sequence indicated, similar to that previously discussed in the description relating to FIG. 3, until all lines of photocharges have been transferred to, and read out of, the horizontal shift register.

As an example, referring to FIG. 6, an interline transfer type device was operated with the following clock voltages corresponding to those shown in Table 1 below. Initially Φ₁ and Φ₂ are in accumulation (voltages A and B, respectively) at -9 volts. Φ₁ and Φ₂ sequentially move to less negative voltage levels, (voltages C and D, respectively) which places them into depletion. During time interval t₅, a more positive voltage is applied to Φ₂ (voltage E) to transfer charges from the photodiode into that phase of the CCD cells. Each phase then returns to accumulation mode before the modified accumulation mode vertical clocking of the present invention begins during time interval t₈. The required voltage levels for the vertical clocking are labeled as A, C and H for Φ₁, and, B,G and I for Φ₂. Values for these voltages are given in Table 1.

**TABLE I**

| | | |
|---|---|---|
| A | -9v | Accumulation for Φ₁ |
| B | -9v | Accumulation for Φ₂ |
| C | -1v | Depletion for Φ₁ |
| D | -1v | Depletion for Φ₂ |
| E | +8v | Photodiode Readout |
| F | -9v | Accumulation for Φ₁ |
| G | -13v | Modified Accumulation for Φ₂ |
| H | -13v | Modified Accumulation for Φ₁ |
| I | -1v | Depletion for Φ₂ |

The various components of the dark current were measured for the device operated in this manner and then compared with those measured using depletion mode clocking. Clocking the vertical CCD gates with the clock sequence suggested here, resulted in a dark current of 4 pA/cm². This is to be compared with the depletion mode clocking where the dark current was measured to be 194 pA/cm², a factor of 47 decrease in vertical CCD dark current. In FIG. 7, the various contributions to the dark current for the device are plotted as a function of device operating temperature. In the figure, the uppermost curve is the dark current due to the CCD shift register regions when conventional depletion mode clocking is employed. The lowermost curve is the dark current due to the CCD shift register regions when the clocking sequence disclosed in this invention is employed. The middle curve in FIG. 6 is the dark current due to the photodiodes of the device and is shown for comparison. It is seen that, at all temperatures, the CCD dark current is significantly reduced by the clocking described in this invention.

## Claims

1. A method for reducing dark current within an interline CCD image sensor (10) comprising the steps of:
providing the interline CCD image sensor (10) with a matrix of pixels arranged in a plurality of rows and columns with a vertical shift register allocated for each of the columns and at least one horizontal shift register (30) operatively coupled to the vertical shift registers (40), wherein each of the columns of pixels are formed with the vertical shift registers having two phases (Φ₁, Φ₂) allocated for each of the pixels and a plurality of gate electrodes (101, 106) of the vertical shift register for each of the pixels, and clocking means for causing the transfer of charge from the pixels to the vertical shift registers and through the horizontal shift register;
applying, at a first time period (t₀), a first set of voltages to the phases (Φ₁, Φ₂) of the gate electrodes (101, 106) of the vertical shift registers (40) sufficient to accumulate holes at a surface of the interline CCD image sensor (10) beneath each gate electrode (101, 106) in the vertical shift registers; **characterized by**
applying, at a second time period (t₁, t₈), a second voltage that is more negative than the first set of voltages to a first set of the gate electrodes (106) while simultaneously applying a third voltage that is a more positive voltage than the first set of voltages and the second voltage to a second set of the gate electrodes (101), the second voltage being of sufficient potential so holes that were accumulated beneath the second set of the gate electrodes (101) during the first time period are collected and stored beneath the first set of the gate electrodes (106) during the second time period;
applying, at a third time period (t₂, t₈), the second voltage to the second set of the gate electrodes (101) while simultaneously applying the third voltage to the first set of the gate electrodes (106), such that the previously accumulated holes beneath the first set of the gate electrodes (106) are transferred beneath the second set of the gate electrodes (101); and
returning the voltages applied to first and second sets of the gate electrodes to their levels at the first time period.

2. The method of claim 1 further including the step of applying, at a fourth time period (t₃ₐ), the second voltage to the first set of the gate electrodes (106) while simultaneously applying the third voltage to the second set of the gate electrodes (101), such that the previously accumulated holes beneath the second set of the gate electrodes (101) are transferred beneath the first set of the gate electrodes (106).

3. The method of claim 1 wherein the step of applying the first set of voltages to the phases (Φ₁, Φ₂) of the vertical shift registers (40) occurs during a readout period of the horizontal shift register (30).

4. The method of claim 1 further including the step of transferring charge from a photodetector in each pixel to a respective vertical shift register by applying, at a fifth time period (t₅), a positive voltage pulse to the first set of the gate electrodes (106) while simultaneously applying a negative pulse to the second set of the gate electrodes (101).

## Patentansprüche

1. Verfahren zum Reduzieren von Dunkelstrom innerhalb eines Interline-CCD-Bildsensors (10), mit den Schritten:
Versehen des Interline-CCD-Bildsensors (10) mit einer Matrix aus Pixeln, die in einer Vielzahl von Reihen und Spalten angeordnet sind, wobei ein vertikales Schieberegister einer jeden Spalte zugeordnet ist und mindestens ein horizontales Schieberegister (30) in Wirkverbindung mit den vertikalen Schieberegistern (40) steht, wobei jede der Spalten aus Pixeln derart ausgebildet ist, dass die vertikalen Schieberegister zwei Phasen (Φ₁, Φ₂) haben, die einem jeden Pixel zugeordnet sind, und eine Vielzahl von Gate-Elektroden (101, 106) des vertikalen Schieberegisters für jedes Pixel, und mit Taktmitteln, die bewirken, dass die Ladungsübertragung von den Pixeln zu den vertikalen Schieberegistern und durch das horizontale Schieberegister erfolgt;
in einem ersten Zeitraum (t₀) Anlegen eines ersten Satzes von Spannungen an die Phasen (Φ₁, Φ₂) der Gate-Elektroden (101, 106) der vertikalen Schieberegister (40), die ausreicht, um Ladungslöcher auf einer Oberfläche des Interline-CCD-Bildsensors (10) unter einer jeden Gate-Elektrode (101, 106) in den vertikalen Schieberegistern anzusammeln, **gekennzeichnet durch** die Schritte:
in einem zweiten Zeitraum (t₁, t₈) Anlegen einer zweiten Spannung, die negativer ist als der erste Satz von Spannungen, an einen ersten Satz der Gate-Elektroden (106), während gleichzeitig eine dritte Spannung, die positiver ist als der erste Satz von Spannungen und die zweite Spannung, an einen zweiten Satz der Gate-Elektroden (101) angelegt wird, wobei die zweite Spannung ein Potential hat, das ausreicht, um Löcher, die während des ersten Zeitraums unter dem zweiten Satz der Gate-Elektroden (101) angesammelt wurden, zu sammeln und während des zweiten Zeitraums unter dem ersten Satz der Gate-Elektroden (106) zu speichern;
in einem dritten Zeitraum (t₂, t₈) Anlegen der zweiten Spannung an den zweiten Satz der Gate-Elektroden (101), während gleichzeitig die dritte Spannung an den ersten Satz der Gate-Elektroden (106) derart angelegt wird, dass die zuvor angesammelten Löcher unter dem ersten Satz der Gate-Elektroden (106) unter den zweiten Satz der Gate-Elektroden (101) übertragen werden; und
Zurücksetzen der Spannungen, die an den ersten und zweiten Satz der Gate-Elektroden angelegt wurden, auf ihr Niveau im ersten Zeitraum.

2. Verfahren nach Anspruch 1, mit dem Schritt des Anlegens der zweiten Spannung in einem vierten Zeitraum (t₃ₐ) an den ersten Satz der Gate-Elektroden (106), während gleichzeitig die dritte Spannung an den zweiten Satz der Gate-Elektroden (101) derart angelegt wird, dass die zuvor angesammelten Löcher unter dem zweiten Satz der Gate-Elektroden (101) unter den ersten Satz der Gate-Elektroden (106) übertragen werden.

3. Verfahren nach Anspruch 1, worin der Schritt des Anlegens des ersten Satzes von Spannungen an die Phasen (Φ₁, Φ₂) der vertikalen Schieberegister (40) während einer Auslesezeit des horizontalen Schieberegisters (30) erfolgt.

4. Verfahren nach Anspruch 1, mit dem Schritt des Übertragens von Ladung von einem Fotodetektor in jedem Pixel zu einem entsprechenden vertikalen Schieberegister durch Anlegen eines positiven Spannungsimpulses in einem fünften Zeitraum (t₅) an den ersten Satz der Gate-Elektroden (106), während gleichzeitig ein negativer Impuls an den zweiten Satz der Gate-Elektroden (101) angelegt wird.

## Revendications

1. Procédé pour réduire le courant d'obscurité dans un capteur d'image CCD interligne (10) comprenant les étapes de :
fourniture du capteur d'image CCD interligne (10) avec une matrice de pixels disposés dans une pluralité de rangées et de colonnes avec un registre à décalage vertical alloué à chacune des colonnes et au moins un registre à décalage horizontal (30) couplé fonctionnellement aux registres à décalage vertical (40), dans lequel chacune des colonnes de pixels est formée avec des registres à décalage vertical ayant deux phases (Φ₁, Φ₂) allouées pour chacun des pixels et une pluralité d'électrodes de grille (101, 106) du registre à décalage vertical pour chacun des pixels, et des moyens de synchronisation pour provoquer le transfert d'une charge des pixels vers les registres à décalage vertical et à travers le registre à décalage horizontal ;
application, au cours d'une première période (t₀), d'un premier ensemble de tensions aux phases (Φ₁, Φ₂) des électrodes de grille (101, 106) des registres à décalage vertical (40) suffisant pour accumuler des trous au niveau d'une surface du capteur d'image CCD interligne (10) au-dessous de chaque électrode de grille (101, 106) dans les registres à décalage vertical ; **caractérisé par**
l'application, au cours d'une deuxième période (t₁, t₈), d'une deuxième tension qui est plus négative que le premier ensemble de tensions à un premier ensemble d'électrodes de grille (106) tout en appliquant simultanément une troisième tension qui est une tension plus positive que le premier ensemble de tensions et la deuxième tension à un deuxième ensemble d'électrodes de grille (101), la deuxième tension ayant un potentiel suffisant pour que les trous qui s'étaient accumulés sous le deuxième ensemble d'électrodes de grille (101) durant la première période soient collectés et stockés sous le premier ensemble d'électrodes de grille (106) pendant la deuxième période ;
l'application, au cours d'une troisième période (t₂, t₈), de la deuxième tension au deuxième ensemble d'électrodes de grille (101) tout en appliquant simultanément la troisième tension au premier ensemble d'électrodes de grille (106), de telle sorte que les trous qui s'étaient précédemment accumulés sous le premier ensemble d'électrodes de grille (106) soient transférés sous le deuxième ensemble d'électrodes de grille (101) ; et
le retour des premières tensions appliquées et du deuxième ensemble d'électrodes de grille à leurs niveaux pendant la première période.

2. Procédé selon la revendication 1 comprenant aussi l'étape d'application, au cours d'une quatrième période (t₃ₐ), de la deuxième tension au premier ensemble d'électrodes de grille (106) tout en appliquant simultanément la troisième tension au deuxième ensemble d'électrodes de grille (101), de telle sorte que les trous qui s'étaient précédemment accumulés sous le deuxième ensemble d'électrodes de grille (101) soient transférés sous le premier ensemble d'électrodes de grille (106).

3. Procédé selon la revendication 1, dans lequel l'étape d'application du premier ensemble de tensions aux phases (Φ₁, Φ₂) des registres à décalage vertical (40) intervient durant une période de lecture du registre à décalage horizontal (30).

4. Procédé selon la revendication 1, comprenant aussi l'étape de transfert de charge d'un photodétecteur dans chaque pixel vers un registre à décalage vertical respectif en appliquant, au cours d'une cinquième période (t₅), une impulsion de tension positive au premier ensemble d'électrodes de grille (106) tout en appliquant simultanément une impulsion négative au deuxième ensemble d'électrodes de grille (101).
